# EUROPÄISCHE PATENTSCHRIFT

(11) **EP 0 821 708 B1**
(45) Veröffentlichungstag und Bekanntmachung des Hinweises auf die Patenterteilung: **09.12.1998**
(21) Anmeldenummer: 96909142.0
(22) Anmeldetag: 28.03.1996
(51) Int. Cl.: C08G 69/28, C08G 69/04

(54) **VERFAHREN ZUR HERSTELLUNG EINES POLYAMIDS AUF DER BASIS EINER DICARBONSÄURE UND EINES DIAMINS**
PROCESS FOR PRODUCING A POLYAMIDE BASED ON A DICARBOXYLIC ACID AND A DIAMINE
PROCEDE DE PREPARATION D'UN POLYAMIDE A BASE D'ACIDE DICARBOXYLIQUE ET D'UNE DIAMINE

(30) Priorität: 15.04.1995 DE 19514145
(43) Veröffentlichungstag der Anmeldung: 04.02.1998
(73) Patentinhaber: BASF AKTIENGESELLSCHAFT, 67056 Ludwigshafen (DE)
(72) Erfinder: GÖTZ, Walter, D-67067 Ludwigshafen (DE); HOFMANN, Jürgen, D-67069 Ludwigshafen (DE); KOPIETZ, Michael, D-67269 Grünstadt (DE); HORLE, Helmut, D-68623 Lampertheim (DE)
(86) Internationale Anmeldenummer: EP9601365
(87) Internationale Veröffentlichungsnummer: WO9633234

(56) Entgegenhaltungen:
- EP-A- 0 123 377
- EP-A- 0 129 195
- EP-A- 0 129 196
- DE-A- 1 720 349
- DE-C- 929 151
- FR-A- 2 220 554

## Beschreibung

Die vorliegende Erfindung betrifft ein verbessertes Verfahren zur Herstellung eines Polymeren auf der Basis einer Dicarbonsäure und eines Diamins durch Polykondensation in einem Extruder.

In der DE-A 1,720,349 wird die Herstellung von höhermolekularem Polyamid-66 mit einem K-Wert im Bereich von 69 bis 72 durch kontinuierliches Weiterkondensieren von niedermolekularem Polyamid-66 mit einem K-Wert im Bereich von 30 bis 60 in einem gleichlaufenden Schneckenreaktor beschrieben.

Nachteilig an diesem Verfahren ist, daß das Verfahren nur zur Nachkondensation geeignet ist, und daß das eingesetzte Präpolymere konventionell in Rührkesseln oder Rohrreaktoren hergestellt werden muß.

Bekanntlich werden bei diesen konventionellen Verfahren, beispielsweise in der DE-A 929 151, der DE-A 24 10 474, der EP-A 129 195 und EP-A 129 196 beschrieben, wäßrige Lösungen der Monomerverbindungen eingesetzt. Diese sind als einphasige Flüssigkeiten problemlos durch Rohrleitungen und Pumpen förderbar. Nachteilig ist, daß große Mengen an Wasser energieaufwendig entfernt werden müssen, bevor die Nachkondensation zu höhermolekularen Polymeren durchgeführt werden kann. Zudem sind konventionelle Reaktoren groß dimensioniert, um die großen Volumina an Wasserdampf aufnehmen zu können. Hiermit einhergehend sind schlechte Raum-Zeit-Ausbeuten. Des weiteren ist der zu entfernende Dampf in der Regel mit Monomeren verunreinigt, so daß er aufwendig gereinigt und die Monomeren zurückgeführt werden müssen. Zudem sind große Reaktoren bei einem Produktwechsel wegen der großen Zwischenläufe sehr ungünstig.

Die EP-A 123 377 beschreibt ein Polykondensationsverfahren zur Herstellung von Polyamiden, indem eine erhitzte Lösung eines Salzes oder eines Präpolymers oder eines Gemisches davon unter Bildung eines Aerosolnebels in einem Verdampfungsreaktor eingespeist wird, wobei dieser Verdampfungsreaktor einen hohen Wärmestrom aufweist und in dem das erhaltene Polymere bis zu 20 Sekunden gehalten wird. Diese Verfahrensweise ist jedoch u.a. wegen des technischen Aufwandes zur Erzeugung von Drücken und hohen Temperaturen, der erforderlichen Kontrolleinheiten und des Umgangs mit dem Aerosolnebel wirtschaftlich ungünstig. Zudem ist das Verfahren wegen der verwendeten hohen Temperaturen bevorzugt zur Herstellung hochtemperaturbeständiger Polyamide auf der Basis aromatischer Dicarbonsäuren und Diamine geeignet.

Aufgabe der vorliegenden Erfindung war es daher ein verbessertes Verfahren zur Verfügung zu stellen, das die genannten Nachteile nicht aufweist. Insbesondere sollte ein Verfahren zur Verfügung gestellt werden, das von festen Monomeren oder Monomermischungen ausgeht, die wenig Wasser enthalten, und zu Polymeren führt, in denen die Differenz Carboxylendgruppen-Aminoendgruppen nicht größer als 80 ist, und die sich schnell zu Polymeren mit hohen Molekulargewichten tempern lassen.

Demgemäß wurde ein Verfahren zur Herstellung eines Polymeren auf der Basis einer Dicarbonsäure und eines Diamins durch Polykondensation in einem Extruder gefunden, indem man
(a) eine bei Raumtemperatur feste Mischung aus einer Dicarbonsäure mit 4 bis 12 C-Atomen und einem Diamin mit 4 bis 12 C-Atomen mit einem Restfeuchtegehalt von weniger als 5 Gew.-% in einem gegenläufigen Doppelschneckenextruder auf eine Temperatur im Bereich von 150 bis 400°C unter autogenem Druck erhitzt unter Erhalt eines Austrags A,
(b) den Austrag A einem gleichläufigen Doppelschneckenextruder zuführt, wobei man den Austrag A einer Temperatur im Bereich von 150 bis 400°C aussetzt und vorhandenes Restwasser sowie Wasser aus der Polykondensation durch Entgasungsöffnungen entfernt, unter Erhalt eines Austrags B, mit der Maßgabe, daß der gleichläufige Doppelschneckenextruder mindestens zwei Segmente mit unterschiedlichen Drücken enthält.

Als Ausgangsmaterial dienen erfindungsgemäß Mischungen aus einer Dicarbonsäure mit 4 bis 12 C-Atomen und einem Diamin mit 4 bis 12 C-Atomen, bevorzugt äquimolare Mischungen mit einem Überschuß einer Komponente von kleiner als 5 Mol-%, bevorzugt von kleiner als 2 Mol-%, besonders bevorzugt von kleiner als 1 Mol-%.

Als Dicarbonsäuren setzt man bevorzugt Adipinsäure, Pimelinsäure, Korksäure, Azelainsäure und Sebazinsäure sowie Terephthalsäure, Isophthalsäure, 5-Sulphoisophthalsäure oder Mischungen der genannten Dicarbonsäuren ein, besonders bevorzugt Adipinsäure.

Als Diamine setzt man bevorzugt Tetramethylendiamin, Hexamethylendiamin, Octamethylendiamin, Decamethylendiamin und Dodecamethylendiamin sowie m-Xylylendiamin, Bis-(4-aminophenyl)methan, Bis-(4-aminophenyl)propan-2,2 und Bis-(4-aminocyclohexyl)methan, oder Mischungen der genannten Diamine ein, besonders bevorzugt Hexamethylendiamin.

In einer bevorzugten Ausführungsform setzt man Hexamethylendiammoniumadipat ("AH-Salz") ein.

Erfindungsgemäß beträgt der Restfeuchtegehalt der eingesetzten Mischung erfindungsgemäß weniger als 5, bevorzugt weniger als 2, besonders bevorzugt weniger als 1,5 Gew.-%.

Erfindungsgemäß führt man eine zuvor genannte Monomermischung einem gegenläufigen Doppelschneckenextruder zu, in dem die Monomermischung aufgeschmolzen wird. Die Wellen des gegenläufigen Doppelschneckenextruders weisen bevorzugt ein Längen:Durchmesser-Verhältnis von 12 bis 50, besonders bevorzugt von 18 bis 36 auf. In einer besonders bevorzugten Ausführungsform wählt man die Wellendurchmesser im Bereich von 25 bis 250, insbesondere von 40 bis 130 mm.

Des weiteren ist bevorzugt, daß der gegenläufige Doppelschneckenextruder in Segmente mit getrennt einstellbaren Temperaturen unterteilt ist, wovon das erste Segment mit einer Länge von 4 bis 8 D bevorzugt auf eine Temperatur im Bereich von 20 bis 180, besonders bevorzugt von 25 bis 100°C unterhalb des Schmelzpunktes des entstehenden Polyamids eingestellt wird. Für die nachfolgenden Segmente wählt man bevorzugt Temperaturen zwischen 5°C unterhalb und 50°C oberhalb, insbesondere zwischen 5 und 50°C oberhalb des Schmelzpunktes des entstehenden Polyamids. In einer besonders bevorzugten Ausführungsform zur Herstellung von Polyamid 66 beträgt der Temperaturbereich für die nachfolgenden Segmente 250 bis 300, insbesondere 260 bis 300, insbesondere 260 bis 275°C.

Ferner wählt man üblicherweise eine Drehzahl im Bereich von 50 bis 250, bevorzugt von 100 bis 200 Umdrehungen/min.

Es ist erfindungswesentlich, daß im gegenläufigen Doppelschneckenextruder ein autogener Druck, der sich aus der gewählten Temperatur und der Flüchtigkeit der Komponenten (Monomere, Reaktionswasser und gegebenenfalls Restfeuchte der Monomermischung) ergibt, herrscht. Dies kann erreicht werden, indem man den Abstand zwischen Extruderwellen und Gehäuseinnenwand so wählt, daß die relative Spaltbreite S = (D-D_{G})/D, wobei D = 2 x Radius der Extruderwelle am Steg und D_{G} = 2 x Gehäuseinnenradius bedeuten, üblicherweise kleiner als 0,02, bevorzugt im Bereich von 0,015 bis 0,0001, besonders bevorzugt im Bereich von 0,006 bis 0,001, beträgt. In einer besonders bevorzugten Ausführungsform mit einem D von 34 mm wählt man einen Abstand von (D - D_{G}) < 0,5, bevorzugt < 0,2 mm, was Werten von S < 0,015, bevorzugt S < 0,006, entspricht.

Des weiteren wählt man üblicherweise eine Drehzahl im Bereich von 50 bis 250, bevorzugt von 100 bis 200 Umdrehungen/min.

Die Verweilzeit im gegenläufigen Extruder wählt man üblicherweise im Bereich von 0,5 bis 8, vorzugsweise von 1 bis 4 min.

Erfindungsgemäß führt man den (schmelzeflüssigen) Austrag A sowie die zugehörigen Gase (Wasserdampf und Monomerdämpfe) des gegenläufigen Doppelschneckenextruders einem gleichläufigen Doppelschneckenextruder zu. Zweckmäßig führt man die Polykondensation bei Temperaturen in flüssiger Phase bei Temperaturen im Bereich von 150 bis 400, vorzugsweise 180 bis 300°C, jedoch oberhalb des Schmelzpunktes des herzustellenden Polymers her. Beispielsweise wählt man zur Herstellung von Polyamid-66 eine Temperatur im Bereich von 255 bis 300, besonders bevorzugt von 260 bis 285°C.

Der gleichläufige (bezogen auf die Drehrichtung der Extruderwellen) Doppelschneckenextruder weist üblicherweise ein Längen:Durchmesser-Verhältnis (L:D) im Bereich von 12 bis 50, bevorzugt von 18 bis 36, auf. In einer besonders bevorzugten Ausführungsform wählt man die Wellendurchmesser im Bereich von 25 bis 250 mm, insbesondere von 40 bis 130 mm.

Des weiteren unterteilt man bevorzugt den gleichläufigen Doppelschneckenextruder in Segmente mit getrennt einstellbaren Temperaturen.

Es ist erfindungswesentlich, daß der gleichläufige Doppelschneckenextruder mindestens 2 Segmente mit unterschiedlichen Drücken enthält.

In einer bevorzugten Ausführungsform umfaßt ein solches Segment den Eintrag der Schmelze aus Stufe a, in dem bevorzugt ein autogener Druck herrschen sollte. Mindestens ein weiteres Segment, bevorzugt zwei bis vier Segmente, enthält mindestens eine Entgasungsöffnung, so daß dort ein geringerer Druck als in dem Segment, in dem die Schmelze aus Stufe a eingetragen wird, herrscht.

Üblicherweise weisen die Segmente eine Länge von mindestens 4 D, bevorzugt 6 bis 18, besonders bevorzugt 6 bis 12 D auf.

Ferner wählt man im allgemeinen über einer Entgasungsöffnung, d.h. an der Extruderaußenseite, einen Druck im Bereich von 1 MPa bis 1 kPa, bevorzugt von 500 kPa bis 50 kPa.

In einer weiteren bevorzugten Ausführungsform verwendet man in Stufe b einen Extruder mit einem ersten Segment, in dem autogener Druck herrscht, und zwei bis vier weiteren Segmente, jeweils Entgasungsöffnungen enthaltend, wobei der Druck über den Entgasungsöffnungen vom zweiten bis zum letzten Segment stufenweise abnimmt. Besonders bevorzugt sind hierbei Anordnungen mit drei Segmenten, wobei man über der Entgasungsöffnung des zweiten Segments einen Druck im Bereich von 1 MPa bis 100 kPa, bevorzugt von 50 bis 10 kPa, wählt. Des weiteren besonders bevorzugt sind Anordnungen mit vier Segmenten, wobei man über der Entgasungsöffnung des zweiten Segments einen Druck im Bereich von 1 MPa bis 100 kPa, bevorzugt von 500 bis 100 kPa, über der Entgasungsöffnung des dritten Segments einen Druck im Bereich von 150 bis 20 kPa, bevorzugt von 50 bis 10 kPa, und über der Entgasungsöffnung des vierten Segments einen Druck im Bereich von 50 bis 1, bevorzugt von 20 bis 5 kPa, mit der Maßgabe, daß der Druck über den Entgasungsöffnungen von Segment zu Segment um mindestens 20 % abnimmt, wählt.

Um Segmente mit unterschiedlichen Drücken zu erhalten, hat es sich nach bisherigen Beobachtungen als vorteilhaft erwiesen, die Schneckenwellen des gleichläufigen Doppelschneckenextruders in Zonen mit unterschiedlicher Gewindesteigung zu unterteilen. Besonders vorteilhaft verwendet man neben den in Förderrichtung wirksamen Gewindesteigungen zwischen den Segmenten, die einen unterschiedlichen Druck aufweisen sollen, jeweils mindestens eine Zone von 0,33 bis 3 D Länge, die entgegengesetzt zur Förderrichtung wirksame Gewindesteigungen aufweisen. In einer besonders bevorzugten Ausführungsform wählt man zusätzlich den Durchsatz - in Abhängigkeit vom Extruderdurchmesser - so hoch, daß die gegenläufigen Zonen mit Schmelze gefüllt sind, so daß sie als druckdichte Barrieren zwischen den - unterschiedliche Drücke aufweisenden - Segmenten wirken.

In einer bevorzugten Ausführungsform speist man den Austrag A in einer Entfernung des (gleichläufigen) Extruders im Bereich von 3 bis 8, besonders bevorzugt von 4 bis 6 D, vom Extruderbeginn ein.

Dabei kann man zur Abdichtung der Schneckenwelle zum Antrieb hin gegen Luftsauerstoff einen Hilfsstoff, vorzugsweise ein Polymer erhalten aus den gleichen Monomereinheiten wie die Monomermischung enthält, einsetzen. Üblicherweise wählt man die Menge dieses Hilfsstoffes in einem Bereich von 0,5 bis 5, bevorzugt von 1 bis 3 Gew.-%, bezogen auf die eingesetzte Monomermischung.

In einer weiteren bevorzugten Ausführungsform kann man als Hilfsstoff auch die üblichen Additive wie Wärme- und UV-Stabilisatoren, Nukleierungsmittel und Pigmente einsetzen.

Die aus den Entgasungsöffnungen austretenden Gase (im wesentlichen dampfförmiges Reaktionswasser und mitgerissene Polymerbestandteile sowie leicht flüchtige Amine) werden bevorzugt gesammelt, mit üblichen Destillationsapparaturen rektifiziert, und in Dampf und Sumpf aufgetrennt. Den Sumpf, bestehend im wesentlichen aus Aminen und mitgerissenen Polymertröpfchen, führt man bevorzugt in den ersten, gegenläufigen Extruder zurück, besonders bevorzugt in das erste Drittel des Extruders, vom Anfang des Extruder her gesehen.

Des weiteren wählt man üblicherweise eine Drehzahl im Bereich von 50 bis 250, bevorzugt von 100 bis 200 Umdrehungen/min.

Die Verweilzeit im gleichläufigen Extruder wählt man im allgemeinen im Bereich von 0,5 bis 8, vorzugsweise von 1 bis 4 min.

Der Austrag B des gleichläufigen Extruders besteht aus einem Polymeren, das eine Viskositätszahl (gemessen an einer 0,5 gew.-%igen Lösung in 96 gew.-%iger Schwefelsäure bei einer Temperatur von 25°C) im Bereich von 40 bis 185, besonders bevorzugt von 45 bis 155, ganz besonders bevorzugt von 50 bis 80 ml/g aufweist.

Besonders bevorzugt wählt man die Differenz Carboxylendgruppen-Aminoendgruppen im Bereich von 50 bis -10, bevorzugt von 30 bis 10.

In der Regel verstrangt man das in Schritt (b) erhaltene Polymere, verfestigt es im Wasserbad und granuliert es anschließend.

In einem weiteren Schritt kann man das in (b) erhaltene Polymere, bevorzugt als Granulat, einer Festphasenkondensation unterwerfen, bevorzugt wenn die Viskositätszahl kleiner als 140, besonders bevorzugt wenn sie kleiner als 120 ml/g beträgt. Vorzugsweise nimmt man die Nachkondensation bei einer Temperatur im Bereich von 10 bis 100°C unterhalb des Schmelzpunktes des herzustellenden Polymeren vor. Beispielsweise wählt man bei der Nachkondensation des Polymeren zur Herstellung von Polyamid-66 eine Temperatur im Bereich von 160 bis 190°C.

Die Verweilzeiten hängen unter anderem vom gewünschten Molekulargewicht des Polymeren ab und liegen in der Regel im Bereich von 2 bis 48 h.

Die Nachkondensation kann man diskontinuierlich oder kontinuierlich durchführen, vorzugsweise in einer Inertgasatmosphäre wie Stickstoff.

Das gewünschte Molekulargewicht des nachkondensierten Polymeren liegt im allgemeinen in einem Bereich, in dem das Polymer eine Viskositätszahl im Bereich von 125 bis 500, bevorzugt von 135 bis 185, besonders bevorzugt von 140 bis 155 g/ml aufweist.

Das erfindungsgemäße Verfahren gestattet es, Polymere mit hohen Viskositätszahlen herzustellen, ohne den apparativen Aufbau den konventionelle Anlagen besitzen. Des weiteren ist es nach dem vorliegenden Verfahren möglich, von Monomeren oder Monomermischungen auszugehen, die kein oder wenig Wasser enthalten, und zu Polymeren mit einem Amino- zu Carboxyl-Endgruppenverhältnis von ungefähr 1 führen, so daß hohe Molekulargewichte möglich sind.

### Beispiele

Die Bestimmung der Carboxylendgruppen erfolgte durch Titration in Benzylalkohol.

### Beispiel 1

Die Viskositätszahlen wurden an einer 0,5 gew.-%igen Lösung in 96 gew.-%iger Schwefelsäure bei einer Temperatur von 25°C bestimmt.

Ein gegenläufiger Doppelschneckenextruder mit D = 34 mm Schneckendurchmesser (Fa. Leistritz) und einer Länge von 36D förderte schleuderfeuchtes AH-Salz (1:1-Addukt aus Adipinsäure und Diaminohexan, durch Abkühlen einer heißen, gesättigten Lösung ausgefällt, durch Abschleudern auf einen Wassergehalt von 1,2 Gew.-% getrocknet) mit den in untenstehender Tabelle angegebenen Temperaturen, Drehzahlen und Durchsätzen.

Dieser Extruder förderte in einen gleichläufigen Zweiwellenextruder von D = 40 mm Schneckendurchmesser (ZSK 40 von Werner + Pfleiderer, Stuttgart) und 40 D Länge, wobei die Schmelze ca. 6D vom Extruderbeginn entfernt zudosiert wurde. Vom Extruderbeginn her wurden 3 Gew.-%, bezogen auf die eingesetzte Menge AH-Salz, eines Polyamid 66 - Präpolymeren von VZ (Viskositätszahl) 59 ml/g, das gemäß EP 129 195 hergestellt worden war, zur Abdichtung der Schneckenwelle gegen Luftsauerstoff gefördert. Nach ca. 16D war eine druckose Entgasung (gegen Atmosphärendruck) angebracht, die mit einer Rektifizierkolonne (Glas-Standardapparatur 29 mm Durchmesser, 60 cm Höhe, Glas-Füllkörper 3 mm Durchmesser, 9 theoret. Böden) verbunden war. Deren Sumpf wurde von einer Kolbenpumpe in den Beginn des Leistritz-Extruders gefördert.

Im weiteren Verlauf des Extruders befand sich eine druckfeste Abdichtung in Form eines 20 mm-Abstauelements, danach eine mit 700 mbar Restdruck betriebene Vakuumentgasung bei ca. 25 D sowie nach einem weiteren Stauelement eine mit 100 mbar Restdruck betriebene zweite Vakuumentgasung bei ca. 31 D. Dieser förderte die Schmelze weiter in eine Entgasungszone, wo durch Anlegen von Vakuum definiert und unter gleichzeitigem Wärmeeintrag entgast wurde.

Die jeweiligen Extruderparameter (Temperatur, Drehzahl, Durchsatz) sind in untenstehender Tabelle angegeben.

### Beispiel 2 (Vergleich)

Beispiel 1 wurde wiederholt, mit dem Unterschied, daß kein gleichläufiger Extruder eingesetzt wurde.

### Beispiel 3 (Vergleich)

Beispiel 1 wurde wiederholt, mit dem Unterschied, daß kein gegenläufiger Extruder eingesetzt wurde. Um eine längere Verweilzeit zu erzielen, wurde ein 30 mm-Extruder (ZSK 30 von Werner + Pfleiderer), der keine Stauelemente enthielt, vor den gleichläufigen Extruder geschaltet.

Alle Polymeren wurden in einen Glas-Rotavapor 8 h bei 170°C unter Stickstoff getempert. Anschließend wurde auf ein Blech extrudiert, abkühlen gelassen und das abgekühlte Produkt gemahlen. Die hierbei erhaltenen Viskositätszahlen der Endprodukte sind ebenfalls in untenstehender Tabelle aufgeführt.

**Tabelle**

| Nr. | Durchsatz [kg/h] | Drehzahl [U/min] | Temperatur [°C] | VZ Polym. [ml/g] | AEG Polym. [mmol/kg] | CEG Polym. [mmol/kg] | VZ Endprod. [ml/g] |
|---|---|---|---|---|---|---|---|
| 1a | 4 | 150 | 275 | 62 | 85 | 95 | 185 |
| 1b | 8 | 150 | 275 | 60 | 64 | 100 | 190 |
| 1c | 12 | 150 | 275 | 58 | 78 | 95 | 187 |
| 1d | 4 | 250 | 275 | 60 | 55 | 129 | 156 |
| 1e | 8 | 250 | 275 | 44 | 42 | 164 | 144 |
| 1f | 4 | 150 | 285 | 55 | 47 | 155 | 150 |
| 1g | 8 | 150 | 285 | 49 | 40 | 164 | 139 |
| | | | | | | | |
| 2a | 4 | 150 | 275 | 22 | 61 | 839 | 26 |
| 2b | 8 | 150 | 275 | 24 | 80 | 524 | 30 |
| 2c | 12 | 150 | 275 | 25 | 71 | 555 | 30 |
| 2d | 4 | 250 | 275 | 28 | 62 | 488 | 30 |
| 2e | 8 | 250 | 275 | 25 | 80 | 601 | 28 |
| 2f | 4 | 150 | 285 | 21 | 155 | 957 | 25 |
| 2g | 8 | 150 | 285 | 19 | 160 | 1020 | 23 |
| | | | | | | | |
| 3a | 4 | 150 | 275 | 18 | 171 | 1313 | 20 |
| 3b | 8 | 150 | 275 | 19 | 151 | 1405 | 21 |
| 3c | 12 | 150 | 275 | 15 | 187 | 1365 | 21 |
| 3d | 4 | 250 | 275 | 15 | 220 | 1300 | 20 |
| 3e | 8 | 250 | 275 | 15 | 240 | 1403 | 20 |
| 3f | 4 | 150 | 285 | 10 | 410 | 1767 | 15 |
| 3g | 8 | 150 | 285 | 15 | 314 | 1650 | 20 |

Die Produkte der Beispiele 2 und 3 waren nicht fadenbildend und nicht granulierbar. Bei der Extrusion dieser Produkte wurde ein starker Amingeruch festgestellt.

## Patentansprüche

1. Verfahren zur Herstellung eines Polymeren auf der Basis einer Dicarbonsäure und eines Diamins durch Polykondensation in einem Extruder, dadurch gekennzeichnet, daß man
(a) eine bei Raumtemperatur feste Mischung aus einer Dicarbonsäure mit 4 bis 12 C-Atomen und einem Diamin mit 4 bis 12 C-Atomen mit einem Restfeuchtegehalt von weniger als 5 Gew.-% in einem gegenläufigen Doppelschneckenextruder auf eine Temperatur im Bereich von 150 bis 400°C unter autogenem Druck erhitzt unter Erhalt eines Austrags A,
(b) den Austrag A einem gleichläufigen Doppelschneckenextruder zuführt, wobei man den Austrag A einer Temperatur im Bereich von 150 bis 400°C aussetzt und vorhandenes Restwasser sowie Wasser aus der Polykondensation durch Entgasungsöffnungen entfernt, unter Erhalt eines Austrags B, mit der Maßgabe, daß der gleichläufige Doppelschneckenextruder mindestens zwei Segmente mit unterschiedlichen Drücken enthält.

2. Verfahren nach Anspruch 1, dadurch gekennzeichnet, daß man als Mischung AH-Salz einsetzt.

3. Verfahren nach Anspruch 1 oder 2, dadurch gekennzeichnet, daß der Austrag B eine Viskositätszahl im Bereich von 40 bis 185 ml/g aufweist.

4. Verfahren nach Anspruch 3, dadurch gekennzeichnet, daß man
(a) einen Austrag B mit einer Viskositätszahl im Bereich von 40 bis 140 ml/g herstellt und
(b) diesen Austrag B in fester Phase zu einem Polymeren mit einer Viskositätszahl von größer als 140 ml/g nach-kondensiert.

5. Verfahren nach den Ansprüchen 1 bis 4, dadurch gekennzeichnet, daß man die Differenz Carboxylendgruppen-Aminoendgruppen des Austrags B im Bereich von 50 bis -10 wählt.

## Claims

1. A process for preparing a polymer based on a dicarboxylic acid and a diamine by polycondensation in an extruder, which comprises
(a) heating a mixture of a dicarboxylic acid having from 4 to 12 carbon atoms and a diamine having from 4 to 12 carbon atoms, which mixture is solid at room temperature and has a residual moisture content of less than 5% by weight, to a temperature in the range from 150 to 400°C under autogenous pressure in a contrarotating twin-screw extruder to give a product A,
(b) feeding the product A to a corotating twin-screw extruder, with the product A being exposed to a temperature in the range from 150 to 400°C and residual water present and also water from the polycondensation being removed through degassing openings, to give a product B, with the proviso that the corotating twin-screw extruder has at least two segments having different pressures.

2. A process as claimed in claim 1, wherein the mixture used is AH salt.

3. A process as claimed in claim 1 or 2, wherein the product B has a viscosity number in the range from 40 to 185 ml/g.

4. A process as claimed in claim 3, wherein
(a) a product B having a viscosity number in the range from 40 to 140 ml/g is prepared and
(b) this product B is further condensed in the solid state to give a polymer having a viscosity number of greater than 140 ml/g.

5. A process as claimed in any of claims 1 to 4, wherein the difference carboxyl end groups-amino end groups of the product B is selected so as to be in the range from 50 to -10.

## Revendications

1. Procédé de préparation d'un polymère à base d'un acide dicarboxylique et d'une diamine par polycondensation dans une extrudeuse, caractérisé en ce que l'on chauffe, sous obtention d'un produit sortant
(a) un mélange solide à la température ambiante et constitué d'un acide dicarboxylique qui comporte de 4 à 12 atomes de carbone et d'une diamine qui comporte de 4 à 12 atomes de carbone, d'une teneur en humidité résiduelle inférieure à 5% en poids, dans une extrudeuse à deux vis tournant en sens contraire jusqu'à une température qui varie de 150 à 400°C et sous la pression autogène,
(b) on introduit le produit sortant A dans une extrudeuse à deux vis tournant dans le même sens, où l'on expose le produit sortant A à une température qui varie de 150 à 400°C et on élimine l'eau résiduelle présente ainsi que l'eau provenant de la polycondensation par des ouvertures de dégazage, sous obtention d'un produit sortant B, avec la condition que l'extrudeuse à deux vis tournant dans le même sens comporte au moins deux segments avec des pressions différentes.

2. Procédé suivant la revendication 1, caractérisé en ce que l'on utilise du sel de AH à titre de mélange.

3. Procédé suivant la revendication 1 ou 2, caractérisé en ce que le produit sortant B présente un indice de viscosité qui varie dans la plage de 40 à 185 ml/g.

4. Procédé suivant la revendication 3, caractérisé en ce que
(a) on prépare un produit sortant B d'un indice de viscosité qui varie de 40 à 140 ml/g, et
(b) on soumet à postcondensation ce produit sortant B en phase solide en un polymère qui présente un indice de viscosité supérieur à 140 ml/g.

5. Procédé suivant les revendications 1 à 4, caractérisé en ce que l'on choisit la différence radicaux terminaux carboxyle - radicaux terminaux amino du produit sortant B dans la plage de 50 à -10.
